# FASCICULE DE BREVET EUROPEEN

(11) **EP 2 337 067 B1**
(45) Date de publication et mention de la délivrance du brevet: **11.12.2013**
(21) Numéro de dépôt: 10194655.6
(22) Date de dépôt: 13.12.2010
(51) Int. Cl.: H01L 21/768, H01L 23/48

(54) **Realisation de structures d'interconnexions TSV formées d'un contour isolant et d'une zône conductrice située dans le contour et disjointe du contour**
Herstellung von TSV-Verbindungsstrukturen, die aus einer isolierenden Konturlinie und einer leitenden Zone bestehen, die sich innerhalb der Konturlinie und abgekoppelt von ihr befindet
Making TSV interconnection structures composed of an insulating contour and a conducting area located in the contour and separate from the contour

(30) Priorité: 15.12.2009 FR 0958999
(43) Date de publication de la demande: 22.06.2011
(73) Titulaire: Commissariat à l'Énergie Atomique et aux Énergies Alternatives, 75015 Paris (FR)
(72) Inventeur: Pares, Gabriel, 38190, Bernin (FR)
(74) Mandataire: Ilgart, Jean-Christophe

(56) Documents cités:
- WO-A1-2010/125164
- US-A1- 2007 069 364
- US-A1- 2008 079 131
- US-A1- 2008 124 845
- US-A1- 2009 057 899

## Description

### DOMAINE TECHNIQUE

L'invention concerne le domaine de la microélectronique et des microsystèmes, et en particulier celui des structures d'interconnexions de via, notamment de type TSV (TSV pour « Through Silicon Via »).

Elle prévoit la mise en oeuvre d'une structure d'interconnexion améliorée.

### ART ANTÉRIEUR

Dans le cadre de la réalisation d'empilements de puces microélectroniques, il est connu de réaliser des éléments d'interconnexions de type dit TSV (TSV pour « Through Silicon Via »), c'est-à-dire des éléments de connexion traversant un substrat pour réaliser une connexion avec une ou plusieurs puces empilées sur ce substrat.

Ces éléments de connexion, également appelés « via », sont classiquement formés d'une partie interne conductrice assurant le passage du courant à travers le substrat et reliant des dispositifs situés de part et d'autre du substrat, ainsi que d'une partie externe isolante, enrobant la partie interne conductrice, et assurant l'isolation du via par rapport au substrat semi-conducteur et à d'autres via environnants, formés dans le substrat.

Les principales étapes de fabrication de ce type de via sont :
- la formation d'un trou dans un substrat,
- la réalisation d'une épaisseur isolante sur les parois du trou,
- le remplissage du trou par dépôt d'un matériau conducteur, par exemple tel que du polysilicium dopé, du tungstène, ou du cuivre.

La fabrication de via traversant pose des problème :
- de remplissage du trou à cause du facteur de forme généralement très élevé de ce dernier ;
- de contraintes mécaniques liées aux matériaux de remplissage utilisés ;
- d'isolation insuffisante ou de capacité parasite trop élevée suivant le diélectrique d'isolation utilisé et l'épaisseur de matériau diélectrique du via.

Les documents WO 2004/084300 A1 et US 6815827 B2 divulguent des procédés de réalisation de via traversant réalisés dans des substrats conducteurs ou semi-conducteurs par isolation d'une partie du substrat par une tranchée formant un contour fermé et isolant, la conduction se faisant à travers une région semi-conductrice isolée du substrat.

Le document US 2009/0181494 A1 prévoit quant à lui une structure d'interconnexion sous forme de plot carré métallique isolé par un contour de forme carrée rempli de matériau diélectrique.

Le brevet US 2009/0032951 A1 divulgue un procédé de réalisation d'une via annulaire traversant une zone isolante formée autour.

Le brevet US 2009/0057899 A1 divulgue un procédé de réalisation d'un via traversant entouré d'une zone d'isolation avec une zone du substrat entre la zone d'isolation et le via. Les ouvertures pour le via et la zone d'isolation sont effectuées sur la face arrière du substrat.

Il se pose le problème de trouver un nouveau procédé de réalisation de structure d'interconnexion de via traversant un substrat.

### EXPOSÉ DE L'INVENTION

La présente invention concerne tout d'abord un procédé de réalisation d'une structure d'interconnexion selon la revendication 1.

Le fait de former une zone d'isolation disjointe de celle de conduction permet de réaliser une isolation de bonne qualité et de limiter l'effet capacitif. Cet avantage peut être déterminant lorsqu'une telle structure est réalisée par exemple pour des circuits RF.

Avec un tel procédé on peut dimensionner aisément la zone entre la première ouverture et la deuxième ouverture et former avec cette zone, une zone de garde pour une reprise de contact.

Selon une possibilité de mise en oeuvre, après la formation de la première ouverture et de la deuxième ouverture :
- on peut déposer ledit matériau diélectrique dans la première et la deuxième ouverture,
- on retire le matériau diélectrique de la deuxième ouverture,
- on forme le matériau conducteur dans la deuxième ouverture.

Selon une autre possibilité de mise en oeuvre, après la formation de la première ouverture et de la deuxième ouverture :
- on peut former ledit matériau conducteur dans la première ouverture et la deuxième ouverture,
- retirer le matériau conducteur de la première ouverture,
- déposer le matériau diélectrique dans la première ouverture.

Le procédé peut comprendre en outre, entre le retrait du matériau diélectrique de la deuxième ouverture et la formation du matériau conducteur dans la deuxième ouverture, une étape d'agrandissement de la deuxième ouverture.

Cette étape d'agrandissement peut être réalisée de manière à former une deuxième ouverture de forme tronconique.

Des ouvertures dotées d'une telle forme peuvent être plus aisément remplies.

Le matériau conducteur peut être formé dans la deuxième ouverture de manière à tapisser le fond et les parois de la deuxième ouverture, le procédé comprenant en outre une étape consistant à combler au moins partiellement la deuxième ouverture par un matériau isolant.

Selon une possibilité de mise en oeuvre, l'étape consistant à combler le reste de la deuxième ouverture par un matériau isolant peut être effectuée lors de ladite étape de dépôt dudit matériau diélectrique dans la première ouverture, ledit matériau isolant permettant de combler au moins partiellement la deuxième ouverture étant ledit matériau diélectrique.

Le substrat peut être à base d'un matériau conducteur ou semi-conducteur.

Le dit matériau conducteur de remplissage peut être un matériau métallique donné, après dépôt du matériau conducteur dans la première ouverture et la deuxième ouverture, puis retrait du matériau conducteur de la première ouverture, on peut réaliser un traitement thermique de manière à former un alliage du matériau semi-conducteur donné et du matériau métallique donné, tel qu'un siliciure.

La seconde ouverture remplie de matériau conducteur forme un élément conducteur. Le procédé peut comprendre en outre : la réalisation d'au moins un plot de connexion sur ledit élément conducteur.

Le procédé comprend en outre une étape d'amincissement du substrat de manière à dévoiler une extrémité dudit élément conducteur.

Selon une possibilité, on peut former un plot conducteur sur ladite extrémité dudit élément conducteur.

Le substrat peut comprendre une ou plusieurs zones conductrices situées sur une de ses faces, ladite formation du trou étant réalisée par gravure depuis l'autre de ses faces de manière à dévoiler au moins une des dites zones conductrices.

La formation de la première et deuxième ouvertures, peut comprendre en outre la réalisation d'une ou plusieurs autres ouvertures situées à l'intérieur du dit contour fermé.

La formation de la première et deuxième ouvertures, peut comprendre en outre la réalisation d'au moins une autre ouverture formant un autre contour fermé entourant le dit contour fermé.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels .
- les figures 1A-1I représentent différents exemples de structures d'interconnexion suivant l'art antérieur ;
- les figures 2A-2F illustrent un premier exemple de procédé de réalisation suivant l'invention d'une structure d'interconnexion de type TSV ;
- les figures 3A-3D illustrent un deuxième exemple de procédé de réalisation suivant l'invention d'une structure d'interconnexion de type TSV ;
- les figures 4A-4B illustrent un autre exemple de procédé de réalisation suivant l'invention d'une structure d'interconnexion de type TSV ;
- les figures 5A-5D illustrent un quatrième exemple de procédé de réalisation suivant l'invention d'une structure d'interconnexion de type TSV ;
- les figures 6A-6E illustrent un cinquième exemple de procédé de réalisation suivant l'invention d'une structure d'interconnexion de type TSV.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

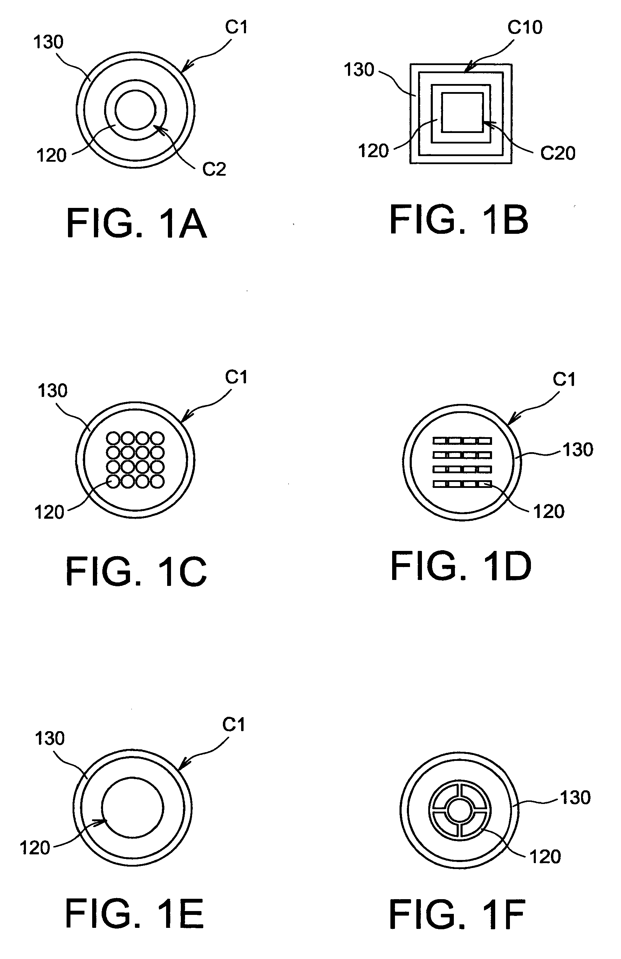

Des exemples de structures d'interconnexion de type TSV, réalisées à l'aide d'un procédé suivant l'invention, sont représentées sur les figures 1A-1I.

Ces structures comprennent au moins un élément conducteur traversant au moins une partie de l'épaisseur d'un substrat et au moins une zone isolante permettant d'isoler l'élément conducteur d'une ou plusieurs autres structures d'interconnexion et du reste du substrat.

La figure 1A illustre un premier exemple de structure d'interconnexion (en vue de dessus) formée dans un substrat et comprenant une zone 130 à base de matériau diélectrique par exemple tel que du Si0₂ et formant un contour C1 fermé de forme circulaire, ainsi qu'un élément conducteur 120 à l'intérieur du premier contour C1, l'élément conducteur 120 pouvant être à base d'un métal par exemple tel que du cuivre, et formant un autre contour C2 de forme circulaire.

Sur l'exemple de la figure 1B, la zone diélectrique 130 forme un contour C10 de forme rectangulaire, tandis que l'élément conducteur 120 forme également un contour rectangulaire C20 disjoint et situé à l'intérieur du contour C10.

Un troisième exemple de structure est donné sur la figure 1C. Dans cet exemple, la zone diélectrique 130 est sous forme d'un contour C1 de forme circulaire à l'intérieur duquel se trouve une pluralité d'éléments conducteurs 120 distincts.

Les éléments conducteurs 120 ont, dans cet exemple, une forme cylindrique.

Un quatrième exemple de structure, diffère de la précédente, en ce que les éléments conducteurs ont une forme de parallélépipède rectangle (figure 1D).

Un autre exemple de structure d'interconnexion comprend une zone de matériau diélectrique 130 sous forme d'un anneau et un élément conducteur 120 sous forme d'un plot cylindrique à l'intérieur dudit anneau (figure 1E).

Un sixième exemple de structure est donné sur la figure 1F, la zone diélectrique 130 étant sous forme d'un contour circulaire C1, tandis que l'élément conducteur 120 est sous forme d'une pluralité d'anneaux conducteurs connectés entre eux par l'intermédiaire de zones conductrices joignant les anneaux.

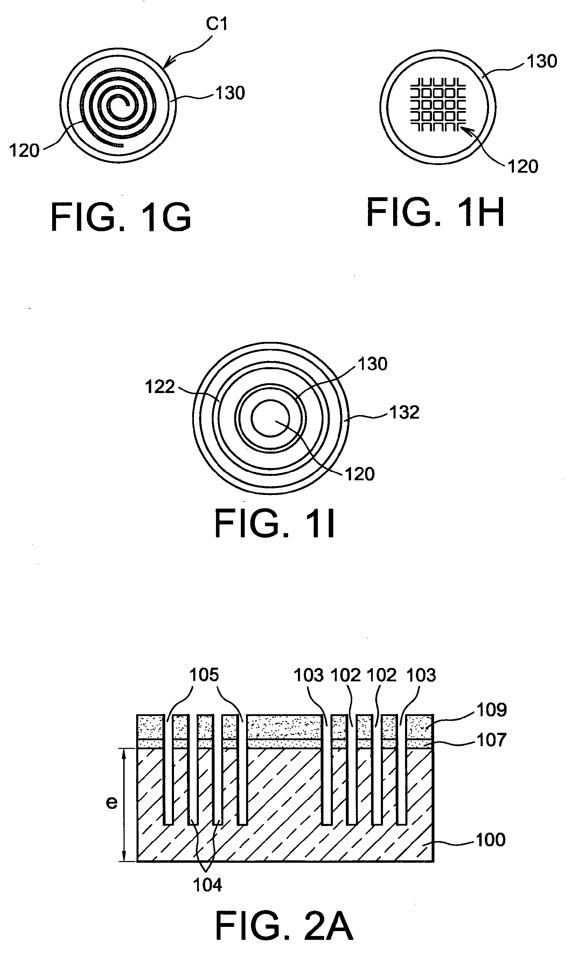

Un septième exemple de structure est donné sur la figure 1G, la zone diélectrique 130 étant sous forme d'un contour circulaire, tandis que l'élément conducteur 120 a une forme de spirale.

Un autre exemple de structure est donné sur la figure 1H, la zone diélectrique 130 étant sous forme d'un contour circulaire, tandis que l'élément conducteur est sous forme d'une grille ou d'un maillage.

Sur la figure 1I, un neuvième exemple de structure d'interconnexion est donné. Dans cet exemple, la zone isolante 130 forme un premier contour circulaire, tandis qu'un élément conducteur 120 est situé à l'intérieur du premier contour circulaire. Un autre élément conducteur 122 forme un autre contour circulaire à l'intérieur duquel la zone isolante 130 et l'élément conducteur 120 sont disposés.

Une autre zone diélectrique 132 sous forme d'un autre contour circulaire entoure les éléments conducteurs 120, 122 et la zone isolante 130.

Dans chacun des exemples de structures qui ont été donnés, une zone isolante et un élément conducteur entouré par cette zone traversent au moins une partie de l'épaisseur du substrat et sont séparées l'un de l'autre par au moins une zone du substrat, qui peut être à base de matériau semi-conducteur.

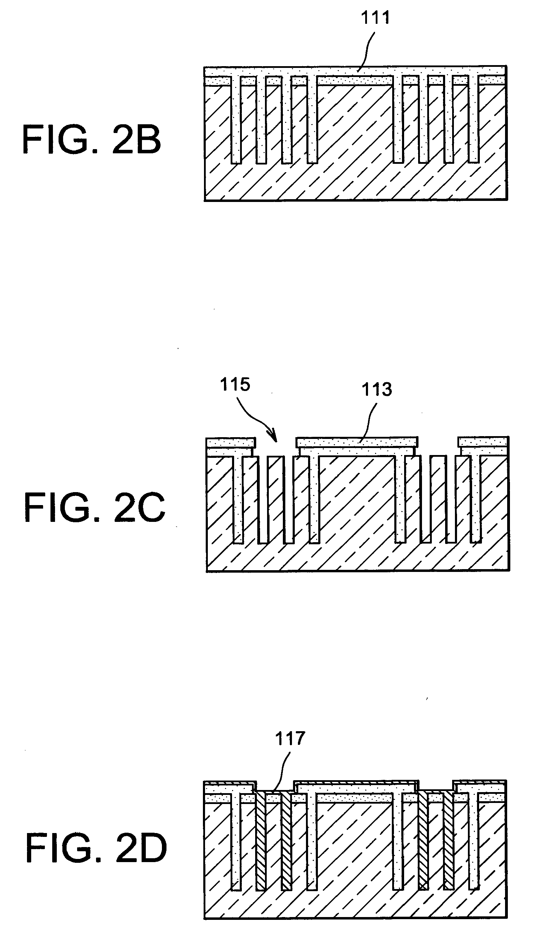

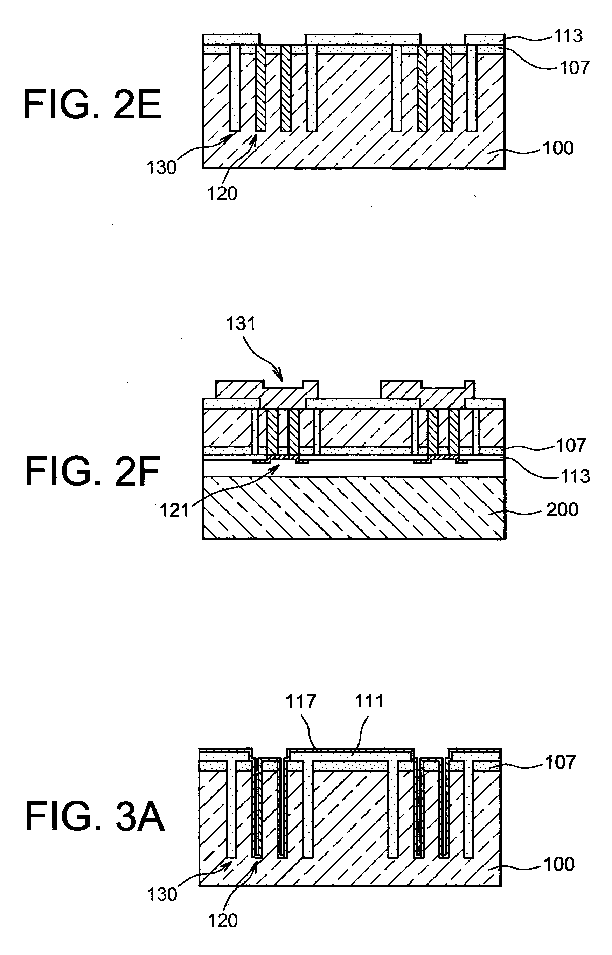

Un premier exemple de procédé, suivant l'invention, de réalisation d'une structure d'interconnexion du type par exemple de celle décrite précédemment en relation avec la figure 1A, va à présent être donné en liaison avec les figures 2A-2F.

Dans cet exemple, le matériau de départ peut être un substrat 100 semi-conducteur, par exemple à base de Si, dans lequel on forme en même temps une ou plusieurs tranchées 103, 105, ainsi qu'un ou plusieurs trous 102, 104, les tranchées 103, 105, et les trous 102, 104 traversant au moins une partie de l'épaisseur e du substrat 100.

Les trous et les tranchées peuvent avoir une profondeur comprise par exemple entre 100 nanomètres et 1 millimètre.

Pour réaliser les tranchées 103, 105, et les trous 102, 104, on peut déposer préalablement une couche de masquage 107, qui peut être par exemple à base de Si0₂ ou de Si₃N₄ et une couche de résine 109, dans lesquels on forme des ouvertures. Puis, on réalise une gravure du substrat à travers ces ouvertures (figure 2A).

Les tranchées sont réalisées de sorte qu'au moins une tranchée 103 forme un contour fermé autour d'une portion de substrat 100 et d'un trou 102, 104.

Les trous sont quant à eux réalisés de sorte qu'au moins un trou 102 forme un contour fermé autour d'une portion de substrat 100.

On retire ensuite la couche de résine 109, puis on remplit les tranchées 103, 105, ainsi que les trous 102, 104, à l'aide d'un matériau diélectrique 111, par exemple tel que du Si0₂. Le remplissage peut être réalisé par dépôt, par exemple un dépôt conforme de type SACVD (SACVD pour « Sub Atmospheric Pressure Chemical Vapor Deposition » selon la terminologie anglo-saxonne) (figure 2B).

Ensuite, on forme un autre masquage 113 de résine comportant des ouvertures 115 situées en regard des trous 102, 104. On retire le matériau diélectrique 111 des trous 102, 104, par exemple par gravure chimique à l'aide de HF ou par gravure sèche, pour un diélectrique de type oxyde, à travers les ouvertures 115 de ce masquage 113.

On dépose ensuite un matériau métallique 117, de manière à remplir les trous 102, 104 (figure 2D).

Le matériau métallique 117 peut être, par exemple, du tungstène qui peut être déposé par exemple par CVD (CVD pour « Chemical Vapour Deposition ») ou par exemple du cuivre qui peut être déposé par exemple par ECD (ECD pour Electro-chemical deposition).

On effectue ensuite un retrait du matériau métallique 117 dépassant de l'embouchure des trous 102, 104.

Ce retrait peut être réalisé par exemple par polissage CMP (CMP pour « Chemical Mechanical Polishing »), de manière à retirer également le matériau diélectrique 111 sur la couche de masquage 107 et dépassant de l'embouchure des tranchées 103, 105 (figure 2E).

On a ainsi réalisé des éléments 120 à base d'un matériau métallique, traversant une partie de l'épaisseur du substrat 100 et situés à l'intérieur d'un contour isolant formé par une zone 130 traversant également une partie de l'épaisseur du substrat 100, les éléments conducteurs 120 étant séparés de la zone isolante 130 par une zone du substrat 100.

On forme ensuite des plots conducteurs 121 en face avant du substrat, sur les trous 102, 104 remplis de matériau métallique 117 de manière à être en contact avec les éléments conducteurs 120.

Un amincissement du substrat 100 par sa face arrière et de manière à dévoiler le fond des trous 102, 104, est ensuite effectué. On réalise ainsi un accès aux éléments conducteurs 120.

Selon une possibilité, pour réaliser l'amincissement, un substrat poignée 200 peut être reporté.

Puis, on forme des plots conducteurs 131 en face arrière du substrat et en contact avec les éléments conducteurs 120.

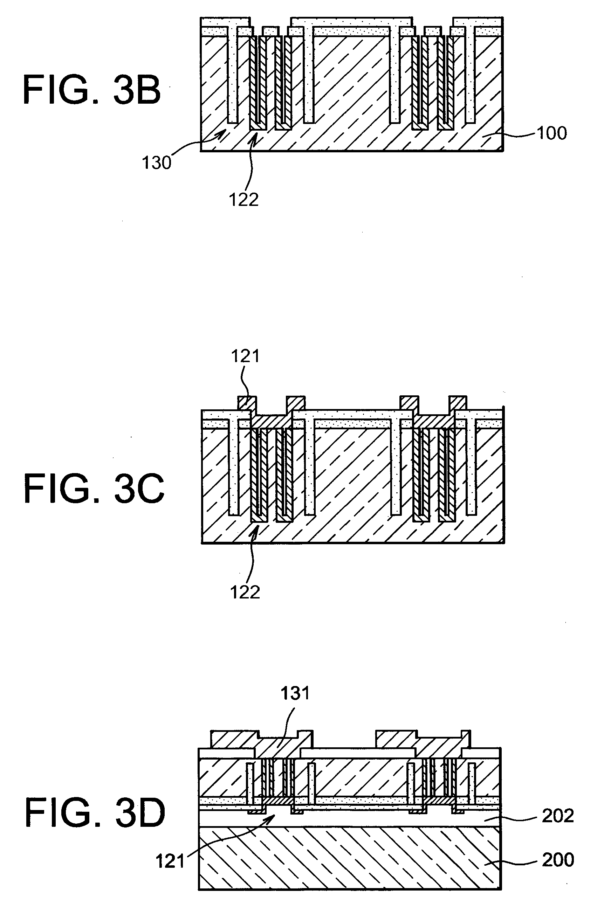

Un deuxième exemple de procédé suivant l'invention, de réalisation d'une structure d'interconnexion, va à présent être donné en liaison avec les figures 3A-3D.

On peut tout d'abord réaliser des étapes comme dans l'exemple de procédé décrit précédemment en liaison avec les figures 2A-2D.

Le matériau métallique 117, peut être ensuite déposé, de manière à tapisser le fond et les parois des trous 102, 104 (figure 3A).

Le matériau métallique déposé peut être par exemple du W, ou du Ti, ou du Ni, ou du Pt, ou du Co, selon une épaisseur par exemple comprise entre 300 et 1000 nanomètres. Le matériau métallique peut être déposé avec une épaisseur prévue de sorte que les trous ne sont pas remplis entièrement.

On réalise ensuite une étape de formation de zones de siliciure 122 dans les trous 102, 104, en effectuant un traitement thermique, par exemple selon une température de l'ordre de 400 °C pour former du siliciure de Ni.

Le siliciure formé peut être par exemple l'un des matériaux suivants : WSi₂, TiSi₂, NiSi, PtSi, CoSi₂ et avoir une épaisseur par exemple comprise entre 1 et 3 micromètres (figure 3B).

On a ainsi formé des éléments conducteurs 122 à base d'un matériau conducteur, traversant une partie de l'épaisseur du substrat 100 et situés à l'intérieur d'un contour isolant formé par une zone 130 traversant également une partie de l'épaisseur du substrat 100, les éléments conducteurs 122 étant séparés de la zone isolante 130 par une zone semi-conductrice du substrat 100.

On forme ensuite des plots conducteurs 121 sur les trous 102, 104 remplis d'alliage de métal et semi-conducteur résultant de la réaction entre le métal 117 et matériau semi-conducteur du substrat 100, de manière à être en contact avec les éléments conducteurs 122 (figure 3C).

Un amincissement du substrat 100 par sa face arrière et de manière à dévoiler le fond des trous 102, 104, est ensuite effectué. On réalise ainsi un accès aux éléments conducteurs 122.

Selon une possibilité, pour réaliser l'amincissement, un substrat poignée 200 peut être reporté.

Puis, on forme des plots conducteurs 131 en face arrière du substrat et en contact avec les éléments conducteurs 122.

Selon une variante de l'un ou l'autre des exemples de procédé qui viennent d'être donnés, préalablement au remplissage des trous 102, 104 par un matériau métallique 117, on peut agrandir ces trous 102, 104, par exemple en réalisant une gravure isotrope de ces derniers à travers les couches 107 et 111.

La gravure peut être effectuée de manière à former des trous 102, 104, comportant des parois inclinées et une forme tronconique. Une telle forme de trous 102, 104 permet un remplissage plus aisé de ces derniers.

On dépose ensuite le matériau métallique 117 selon une épaisseur conforme au fond et sur les parois des trous 102, 104.

L'épaisseur de matériau métallique 117 déposé peut être prévue de sorte qu'après dépôt, la partie centrale des trous 102, 104 n'est pas comblée.

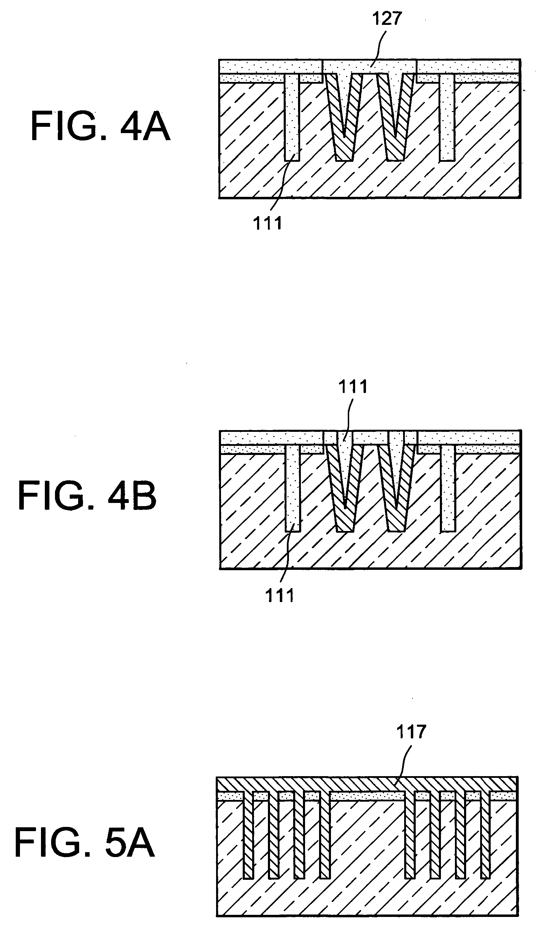

On comble alors cette partie à l'aide d'un matériau diélectrique 127 (figure 4A).

Selon une possibilité illustrée sur la figure 4B, la partie centrale des trous peut être comblée à l'aide du matériau diélectrique 111 à l'aide duquel on remplit les tranchées 103, 105 (figure 4B).

Un autre exemple de procédé de réalisation d'une structure d'interconnexion est donné sur les figures 5A-5D.

On peut réaliser tout d'abord des étapes telles que données précédemment en liaison avec la figure 2A.

Puis, on effectue un remplissage des trous 102, 104 et des tranchées 103, 105 à l'aide d'un matériau métallique 117.

Le remplissage peut éventuellement dépasser de l'embouchure des trous 102, 104 et des tranchées 103 (figure 5A). On retire le métal dépassant des trous 102, 104 par CMP.

Ensuite, on forme un autre masquage 114 de résine comportant des ouvertures 116 situées en regard des tranchées 103, 105.

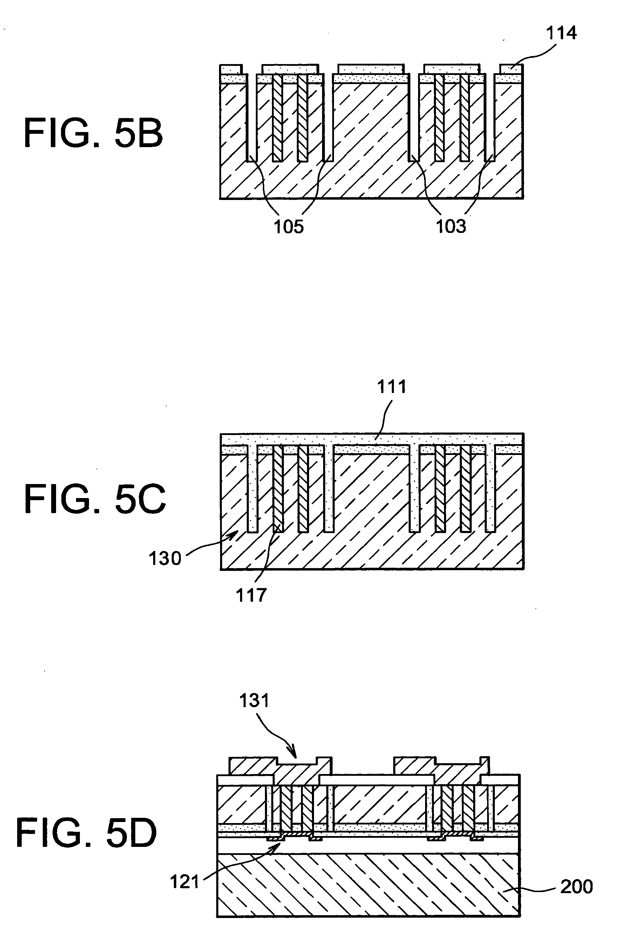

On retire le matériau métallique 117 des tranchées 103, 105, par exemple par gravure chimique à l'aide de HF - HN0₃ lorsque le matériau métallique est du tungstène à travers les ouvertures 116 de ce masquage 114 (figure 5B). On retire le masquage 114 par procédé de décapage communément appelé « stripping ».

Puis, on réalise un remplissage des tranchées 103, 105 à l'aide d'un matériau diélectrique 111.

Le remplissage peut être effectué de manière à dépasser de l'embouchure des trous 102, 104 et des tranchées 103, 105 (figure 5C).

On a ainsi formé des éléments 120 à base d'un matériau métallique, traversant une partie de l'épaisseur du substrat 100 et situés à l'intérieur d'un contour isolant formé par une zone 130 traversant également une partie de l'épaisseur du substrat 100, les éléments conducteurs 117 étant séparés de la zone isolante 130 par une zone semi-conductrice du substrat 100.

On réalise ensuite des ouvertures dans la couche de matériau diélectrique 111, de manière à dévoiler les trous 102, 104.

Puis, on forme des plots conducteurs 121 sur les éléments conducteurs à base de matériau métallique 117.

Des étapes d'amincissement du substrat 100 de manière à dévoiler les trous 102, 104 en face arrière du substrat 100, puis, de formation de plots conducteurs 131 en face arrière du substrat 100 et en contact avec les éléments conducteurs 117, sont ensuite réalisées (figure 5D).

Un procédé ne faisant pas partie de l'invention de réalisation d'interconnexions peut être mis en ouvre lors d'étapes dites « post process », par exemple dans un substrat 100, une fois que celui-ci a été assemblé avec un substrat poignée 200.

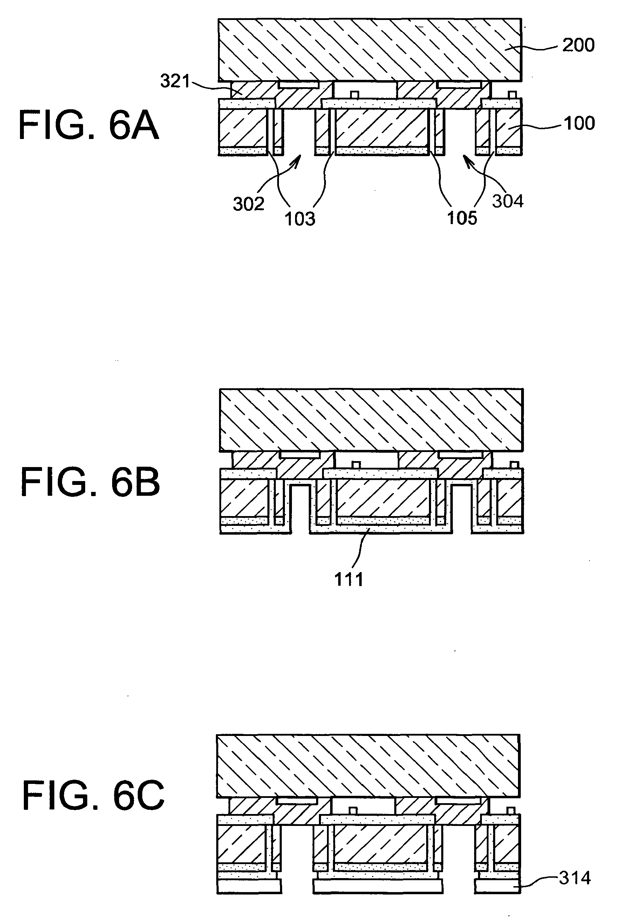

Un exemple de procédé « post process », de réalisation d'une structure de type TSV, est illustré sur les figures 6A-6E.

La structure réalisée peut avoir par exemple une forme semblable à celle par exemple décrite précédemment en liaison avec la figure 1E.

Dans cet exemple, la structure de départ du procédé est formée d'un substrat 100 reporté sur un substrat poignée 200 et éventuellement aminci.

On forme tout d'abord une ou plusieurs tranchées 103, 105, ainsi qu'un ou plusieurs trous 302, 304, à travers un masquage 109, les tranchées 103, 105, et les trous 302, 304 traversant l'épaisseur du substrat 100.

Les trous 302, 304 sont formés en regard des plots conducteurs 321, de manière à dévoiler ces plots 321.

Les tranchées sont réalisées de sorte qu'au moins une tranchée 103 forme un contour fermé autour d'une portion de substrat et d'un trou 302, 304.

Les trous 302, 304 étant quant à eux entourés par le matériau du substrat 100 (figure 6A).

Puis, on réalise un remplissage des tranchées 103, 105 à l'aide d'un matériau diélectrique 111 (figure 5C) .

Le remplissage peut être effectué de manière à recouvrir les parois et le fond des trous 302, 304, et à dépasser de l'embouchure des trous 102, 104 et des tranchées 103, 105 (figure 6B).

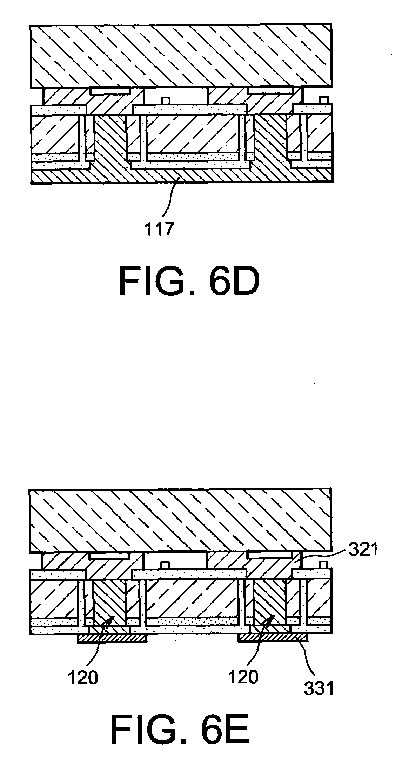

On retire ensuite le matériau diélectrique 111 des trous 302, 304, par exemple par gravure chimique à l'aide de HF lorsque le diélectrique est du Si0₂ à travers les ouvertures d'un masque de résine 314 (figure 6C). Puis, après avoir retiré, le masque de résine 314, on réalise un remplissage des trous 302, 304, à l'aide d'un matériau métallique 117 (figure 6D).

Le remplissage peut avoir été effectué de manière à dépasser de l'embouchure des trous 302, 304 et des tranchées 103, 105. Dans ce cas, on retire le matériau métallique 117, en excédant, dépassant des trous 302, 304, par exemple par polissage CMP.

On a ainsi formé des éléments conducteurs 120 en contact avec des plots de connexion 321. Puis, on forme d'autres plots conducteurs 331, en contact avec les éléments conducteurs 120 sur la face du substrat 100 opposée à celle sur laquelle sont disposés les plots de connexion 321 (figure 6E).

## Revendications

1. Procédé de réalisation d'une structure d'interconnexion avec au moins un via traversant un substrat (100) comprenant : la formation simultanée, sur une face avant du substrat d'au moins une première ouverture (103, 105) réalisant un contour fermé et d'au moins une deuxième ouverture non traversante (102, 104) située à l'intérieur dudit contour fermé, la première ouverture et la deuxième ouverture étant séparées par une zone du substrat, le procédé comprenant en outre :
- des étapes de remplissage d'un matériau:
* diélectrique (111) dans la première et la seconde ouverture, le retrait du matériau dans la deuxième ouverture, la formation ou le dépôt d'un matériau conducteur (117) dans la deuxième ouverture ; ou
* conducteur (117) dans la première et la seconde ouverture, le retrait du matériau dans la première ouverture, la formation ou le dépôt d'un matériau diélectrique (122) dans la première ouverture ;
- une étape d'amincissement d'une face arrière du substrat, opposée à la face avant, de manière à dévoiler le fond de la seconde ouverture.

2. Procédé de réalisation d'une structure d'interconnexion selon la revendication 1, après dépôt du matériau conducteur dans la première ouverture et la deuxième ouverture, et retrait du matériau conducteur de la première ouverture, on réalise une traitement thermique de manière à former un alliage (122) du matériau du substrat et du matériau conducteur.

3. Procédé selon la revendication 1 ou 2, le matériau conducteur (117) étant formé dans la deuxième ouverture de manière à tapisser le fond et les parois de la deuxième ouverture, le procédé comprenant ensuite une étape consistant à combler le reste de la deuxième ouverture par un matériau isolant (127).

4. Procédé selon l'une des revendications 1 à 3, l'étape consistant à combler le reste de la deuxième ouverture par un matériau isolant étant effectuée en même temps que le dépôt du matériau diélectrique (111) dans la première ouverture (103, 105), le matériau diélectrique (111) comblant le reste de la deuxième ouverture.

5. Procédé de réalisation d'une structure d'interconnexion selon l'une des revendications 1, 3 ou 4, comprenant en outre, entre le retrait du matériau diélectrique (111) de la deuxième ouverture (102, 104) et le dépôt ou la formation du matériau conducteur (117, 122) dans la deuxième ouverture, une étape d'agrandissement de la deuxième ouverture.

6. Procédé de réalisation d'une structure d'interconnexion selon l'une des revendications 1 à 5, dans lequel le substrat (100) est à base d'un matériau conducteur ou semi-conducteur donné et le matériau conducteur (117) est un matériau métallique.

7. Procédé de réalisation d'une structure d'interconnexion selon l'une des revendications 1 à 6, dans lequel la deuxième ouverture (102, 104) remplie de matériau conducteur forme un élément conducteur (120, 122), le procédé comprenant en outre la réalisation d'au moins un plot de connexion (121) sur ledit élément conducteur.

8. Procédé de réalisation d'une structure d'interconnexion selon l'une des revendications 1 à 7, dans lequel la deuxième ouverture est remplie de matériau conducteur formant un élément conducteur, le procédé comprenant en outre une étape d'amincissement d'au moins une face du substrat de manière à dévoiler une extrémité dudit élément conducteur (120, 122).

9. Procédé de réalisation d'une structure d'interconnexion selon la revendication 8, comprenant en outre la réalisation d'un plot conducteur (131) sur ladite extrémité dudit élément conducteur (120, 122).

10. Procédé de réalisation d'une structure d'interconnexion selon l'une des revendications 1 à 9, dans lequel le substrat comprend une ou plusieurs zones conductrices (321) située sur une de ses faces, ladite formation de la deuxième ouverture est réalisée par gravure depuis l'autre de ses faces de manière à dévoiler au moins une des dites zones conductrices.

11. Procédé de réalisation d'une structure d'interconnexion selon l'une des revendications 1 à 10, ladite formation simultanée, comprenant la réalisation d'une ou plusieurs autres ouvertures situées à l'intérieur dudit contour fermé.

12. Procédé de réalisation d'une structure d'interconnexion selon l'une des revendications 1 à 11, ladite formation simultanée comprenant la réalisation d'au moins une autre ouverture formant un autre contour fermé entourant ledit contour fermé.

## Patentansprüche

1. Verfahren zur Herstellung einer Verbindungsstruktur mit wenigstens einem ein Substrat (100) durchquerenden VIA, umfassend : die simultane Bildung - auf einer Vorderseite des Substrats - von wenigstens einer eine geschlossene erste Kontur realisierenden Öffnung (103, 105) und wenigstens einer nicht-durchquerenden, innerhalb der genannten geschlossenen Kontur befindlichen zweiten Öffnung (102, 104), wobei die erste Öffnung und die zweite Öffnung durch eine Zone des Substrats getrennt sind und das Verfahren außerdem umfasst :
- Schritte zum Füllen :
* der ersten und der zweiten Öffnung mit einem dielektrischen Material (111), das Entfernen des Materials aus der zweiten Öffnung, das Bilden oder Abscheiden eines leitenden Materials (117) in der zweiten Öffnung ; oder
* der ersten und der zweiten Öffnung mit einem leitenden Material (117), das Entfernen des Materials aus der ersten Öffnung, das Bilden oder Abscheiden eines dielektrischen Materials (122) in der ersten Öffnung ;
- einen Schritt zum Dünnermachen einer der Vorderseite entgegengesetzten Rückseite des Substrats bis zur Freilegung des Bodens der zweiten Öffnung.

2. Verfahren zur Herstellung einer Verbindungsstruktur nach Anspruch 1, beim dem man, nach dem Abscheiden des leitenden Materials in der ersten Öffnung und der zweiten Öffnung und Entfernen des leitenden Materials aus der ersten Öffnung, eine Wärmebehandlung durchführt, um eine Legierung (122) aus dem Material des Substrats und dem leitenden Material zu bilden.

3. Verfahren nach Anspruch 1 oder 2, bei dem das leitende Material (117) in der zweiten Öffnung so gebildet wird, dass es den Boden und die Wände der zweiten Öffnung überzieht, wobei das Verfahren anschließend einen Schritt umfasst, der darin besteht, den Rest der zweiten Öffnung mit einem isolierenden Material (127) auszufüllen.

4. Verfahren nach einem der Ansprüche 1 bis 3, wobei der Schritt, der darin besteht, den Rest der zweiten Öffnung mit einem isolierenden Material auszufüllen, gleichzeitig mit dem Abscheiden des dielektrischen Materials (111) in der ersten Öffnung (103, 105) erfolgt, wobei das dielektrische Material (111) den Rest der zweiten Öffnung ausfüllt.

5. Verfahren zur Herstellung einer Verbindungsstruktur nach einem der Ansprüche 1, 3 oder 4, außerdem - zwischen dem Entfernen des dielektrischen Materials (111) der zweiten Öffnung (102, 104) und dem Abscheiden oder Bilden des leitenden Materials (117, 122) in der zweiten Öffnung -, einen Schritt zur Vergrößerung der zweiten Öffnung umfassend.

6. Verfahren zur Herstellung einer Verbindungsstruktur nach einem der Ansprüche 1 bis 5, bei dem das Substrat (100) auf einem bestimmten leitenden oder halbleitenden Material basiert und das leitende Material (117) ein metallisches Material ist.

7. Verfahren zur Herstellung einer Verbindungsstruktur nach einem der Ansprü-che 1 bis 6, bei dem die mit Material gefüllte zweite Öffnung (102, 104) ein leitendes Element (120, 122) bildet, wobei das Verfahren außerdem die Realisierung von wenigstens einem Verbindungskontaktelement (121) auf dem genannten leitenden Element umfasst.

8. Verfahren zur Herstellung einer Verbindungsstruktur nach einem der Ansprüche 1 bis 7, bei dem die zweite Öffnung mit einem ein leitendes Element bildenden Material gefüllt ist, wobei das Verfahren außerdem einen Schritt zum Dünnermachen von wenigstens einer Seite des Substrats umfasst, um ein Ende des genannten leitenden Elements (120, 122) freizulegen.

9. Verfahren zur Herstellung einer Verbindungsstruktur nach Anspruch 8, außerdem die Realisierung eines leitenden Kontaktelements (131) auf dem genannten Ende des genannten leitenden Elements (120, 122) umfassend.

10. Verfahren zur Herstellung einer Verbindungsstruktur nach einem der Ansprüche 1 bis 9, bei dem das Substrat eine oder mehrere auf einer seiner Seiten befindliche leitende Zonen (321) umfasst, wobei die genannte Bildung der zweiten Öffnung durch Ätzung von der anderen seiner Seiten aus erfolgt, so dass wenigstens eine der genannten leitenden Zonen freigelegt wird.

11. Verfahren zur Herstellung einer Verbindungsstruktur nach einem der Ansprüche 1 bis 10, wobei die genannte simultane Bildung die Realisierung einer oder mehrerer weiterer im Innern der genannten geschlossenen Kontur befindlicher Öffnungen umfasst.

12. Verfahren zur Herstellung einer Verbindungsstruktur nach einem der Ansprüche 1 bis 11, wobei die genannte simultane Bildung die Realisierung von wenigstens einer weiteren Kontur umfasst, die eine die gegebene geschlossene Kontur einschließende weitere geschlossene Kontur bildet.

## Claims

1. A method for producing an interconnection structure with at least one via passing through a substrate (100) comprising: the simultaneous formation, on the substrate a front face, of at least one first opening (103, 105) producing a closed contour and at least one second opening (102, 104) not passing through the substrate and situated inside said closed contour, the first opening and the second opening being separated by a zone of the substrate, the method further comprising:
- the steps of:
* filling a dielectric material (111) in the first and second opening, the removal of the dielectric material in the second opening, the formation or deposition of a conductive (117) material in the second opening, or
* filling a conductive material (117) in the first and second opening, the removal of the conductive material in the first opening, the formation or deposition of a dielectric material (122) in the first opening;
- a step of thinning a rear face of the substrate opposite the front face, so as to expose the bottom of the second opening.

2. The method for producing an interconnection structure according to claim 1 wherein, after deposition of the conducting material in the first opening and the second opening, and removal of the conducting material from the first opening, a heat treatment is done so as to form an alloy (122) of the material of the substrate and the conducting material.

3. The method according to any of claims 1 or 2, the conducting material (117) being formed in the second opening so as to cover the bottom and the walls of the second opening, the method then comprising a step consisting of filling in the rest of the second opening with an insulating material (127).

4. The method according to claims 1 to 3, the step consisting of filling in the rest of the second opening with an insulating material being done at the same time as the deposition of the dielectric material (111) in the first opening (103, 105), the dielectric material (111) filling in the rest of the second opening.

5. The method for producing an interconnection structure according to claim 1, 3, or 4, also comprising, between the removal of the dielectric material (111) from the second opening (102, 104) and the deposition or formation of the conducting material (117, 122) in the second opening, a step for enlarging the second opening.

6. The method for producing an interconnection structure according to any of the claims 1 to 5, wherein the substrate (100) has a base of a given conducting or semi-conducting material and the conducting material (117) is a metal.

7. The method for producing an interconnection structure according to any of the claims 1 to 6, wherein the second opening (102, 104) filled with conducting material forms a conductor member (120, 122), the method also comprising the production of at least one connecting stud (121) on said conductor member.

8. The method for producing an interconnection structure according to one of the claims 1 to 7, wherein the second opening is filled with conducting material forming a conductor member, the method also comprising a step for thinning at least one face of the substrate so as to reveal one end of said conductor member (120, 122).

9. The method for producing an interconnection structure according to claim 8, also comprising the production of a conducting stud (131) on said end of said conductor member (120, 122).

10. The method for producing an interconnection structure according to any of claims 1 to 9, wherein the substrate comprises one or several conducting zones (321) situated on one of its faces, said formation of the second opening is done by etching from the other of its faces so as to reveal at least one of said conducting zones.

11. The method for producing an interconnection structure according to any of the claims 1 to 10, said simultaneous formation comprising the production of one or several other openings situated inside said closed contour.

12. The method for producing an interconnection structure according to one of claims 1 to 11, said simultaneous formation comprising the production of at least one other opening forming another closed contour surrounding said closed contour.
